# EUROPEAN PATENT APPLICATION

(11) **EP 4 145 545 A1**
(43) Date of publication of application: **08.03.2023**
(21) Application number: 21796977.3
(22) Date of filing: 29.04.2021
(51) Int. Cl.: H01L 41/053

(54) **SEMICONDUCTOR STRUCTURE HAVING STACKED UNITS AND MANUFACTURING METHOD THEREFOR, AND ELECTRONIC DEVICE**

(30) Priority: 29.04.2020 CN 202010358033
(71) Applicant: ROFS MICROSYSTEM (TIANJIN) CO., LTD., Tianjin 300462 (CN)
(72) Inventor: ZHANG, Wei, Tianjin 300462 (CN); PANG, Wei, Tianjin 300072 (CN); XU, Yang, Tianjin 300462 (CN); YANG, Qingrui, Tianjin 300072 (CN)
(74) Representative: Meyer-Dulheuer MD Legal Patentanwälte PartG mbB
(86) International application number: PCT/CN2021/090819
(87) International publication number: WO 2021/219051

(57) **Abstract**

The present disclosure relates to a semiconductor structure having stacked units, including: at least two units sequentially stacked in a thickness direction of the semiconductor structure. Each unit includes a substrate, and an accommodating space is defined between substrates of adjacently stacked upper unit and lower unit; the at least two units include an uppermost unit and a lowermost unit, the substrate of at least one of the at least two units, other than the lowermost unit, is a double-sided functional substrate, and the upper and lower sides of the double-sided functional substrate are respectively provided with acoustic devices. The present disclosure also relates to a manufacturing method for the semiconductor structure having stacked units, and an electronic device having the structure.

## Description

### TECHNICAL FIELD

Embodiments of the present disclosure relate to the field of semiconductors, and in particular, to a semiconductor structure and a manufacturing method therefor, and an electronic device having the semiconductor structure.

### BACKGROUND

With the rapid development of the current wireless communication technologies, the application of miniaturized portable terminal devices has become increasingly widespread, and thus the demand for high-performance and small radio frequency front-end modules and devices is increased. In recent years, the filter devices such as a filter and a duplexer that include a film bulk acoustic resonator (referred to as FBAR), are increasingly popular in the market. This is because, on one hand, such filter devices have excellent electrical properties, such as low insertion loss, steep transition characteristics, high selectivity, high power capacity, and strong anti-static discharge (ESD) capability, and on the other hand, have the features of small volume and easy integration.

However, there is still a need to further reduce the sizes of the filter devices.

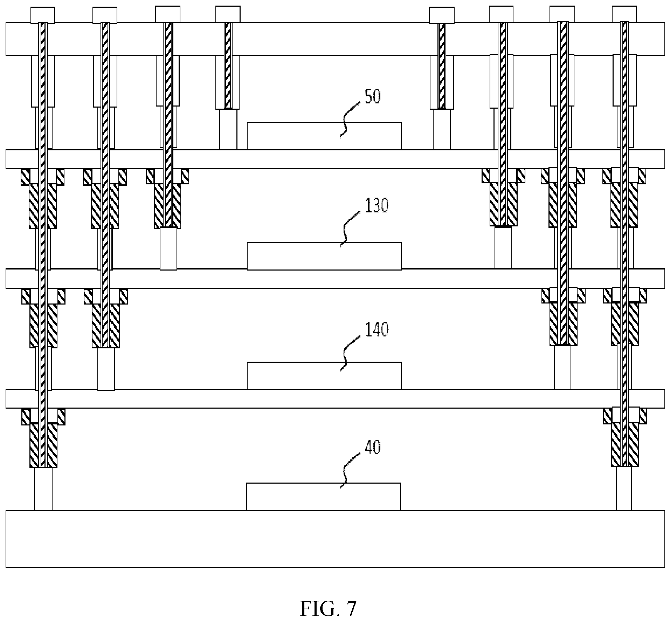

In addition, FIG. 7 shows a known semiconductor structure arranged in a stacked manner, in which four acoustic units (which may be filters) 40, 140, 130 and 50 are arranged on four substrates, respectively. In the embodiment shown in FIG. 7, on the basis of the mode as shown in FIG. 7, N+1 wafers or substrates are required to achieve the complete packaging of N (N is a natural number) acoustic units, or when there is no topmost capping layer substrate (no acoustic unit is arranged on the surface), at most N acoustic units are integrated onto the N wafers.

### SUMMARY

In order to alleviate or solve at least one aspect of the above problems in the related art, the present disclosure is provided.

According to one aspect of embodiments of the present disclosure, there is provided a semiconductor structure with stacked units. The semiconductor structure includes at least two units sequentially stacked in a thickness direction of the semiconductor structure, each of the at least two units includes a substrate, and an accommodating space is provided between substrates of adjacently stacked upper unit and lower unit. The at least two units include an uppermost unit and a lowermost unit, the substrate of at least one of the at least two units, other than the lowermost unit, is a double-side functional substrate, and upper and lower sides of the double-side functional substrate are provided with acoustic components, respectively.

The embodiments of the present disclosure further relate to a method of manufacturing a semiconductor structure with stacked units. The method includes: providing a first substrate that is provided with a first acoustic component on an upper side thereof; providing a second substrate that is provided with a lower acoustic component on a lower side thereof; arranging the first substrate and the second substrate to be opposite each other, and providing an accommodating space between the upper side of the first substrate and the lower side of the second substrate, the first acoustic component and the lower acoustic component being located in the accommodating space; and providing an upper acoustic component on an upper side of the second substrate.

The embodiments of the present disclosure further relate to an electronic device including the above semiconductor structure.

### BRIEF DESCRIPTION OF DRAWINGS

The following description and drawings may help understand these and other features and advantages in various embodiments of the present disclosure. The same reference signs in the drawings always indicate the same components.
FIG. 1A is a schematic top view of a semiconductor structure according to an exemplary embodiment of the present disclosure.
FIG. 1B is a schematic sectional view along a dashed line in FIG. 1A according to an exemplary embodiment of the present disclosure.
FIG. 2A is a schematic top view of a semiconductor structure according to another exemplary embodiment of the present disclosure.
FIG. 2B is a schematic sectional view along a dashed line in FIG. 2A according to another exemplary embodiment of the present disclosure.
FIG. 3A is a schematic top view of a semiconductor structure according to yet another exemplary embodiment of the present disclosure.
FIG. 3B is a schematic sectional view along a dashed line in FIG. 3A according to yet another exemplary embodiment of the present disclosure.
FIG. 3C is a bottom view as viewed in a direction of an arrow in FIG. 3B.
FIG. 4 is a schematic sectional view along a dashed line similar to FIG. 1A according to yet another exemplary embodiment of the present disclosure.
FIG. 5-1, FIGS. 5-2A to 5-2C, and FIGS. 5-3 to 5-6 exemplarily illustrate a manufacturing process of the structure shown in FIG. 1B.
FIGS. 6-1 to 6-7 illustrate a manufacturing process of the structure in FIG. 2B.
FIG. 7 illustrates a known semiconductor structure arranged in a stacked manner.

### DESCRIPTION OF EMBODIMENTS

The technical solutions of the present disclosure will be further described in detail below through embodiments and in conjunction with the drawings. The following description of the embodiments of the present disclosure with reference to the drawings is intended to explain the general inventive concept of the present disclosure, and should not be construed as limitation to the present disclosure.

In the present disclosure, a semiconductor structure includes a plurality of substrates, which is stacked in a thickness direction. Acoustic components, such as FBAR components, are provided on upper and lower sides of the same substrate, such that the amount or number of substrates can be reduced to greatly reduce the dimension of a resulting semiconductor structure and correspondingly reduce the packaging dimension.

In the present disclosure, the acoustic component may be a resonator (a bulk acoustic wave resonator or a surface acoustic resonator), a filter, a duplexer, a multiplexer, and the like. In the sectional views shown in the present disclosure, a bulk acoustic wave resonator is mainly used as the acoustic component for illustration.

The technical solutions of the present disclosure will be described below with reference to the figures.

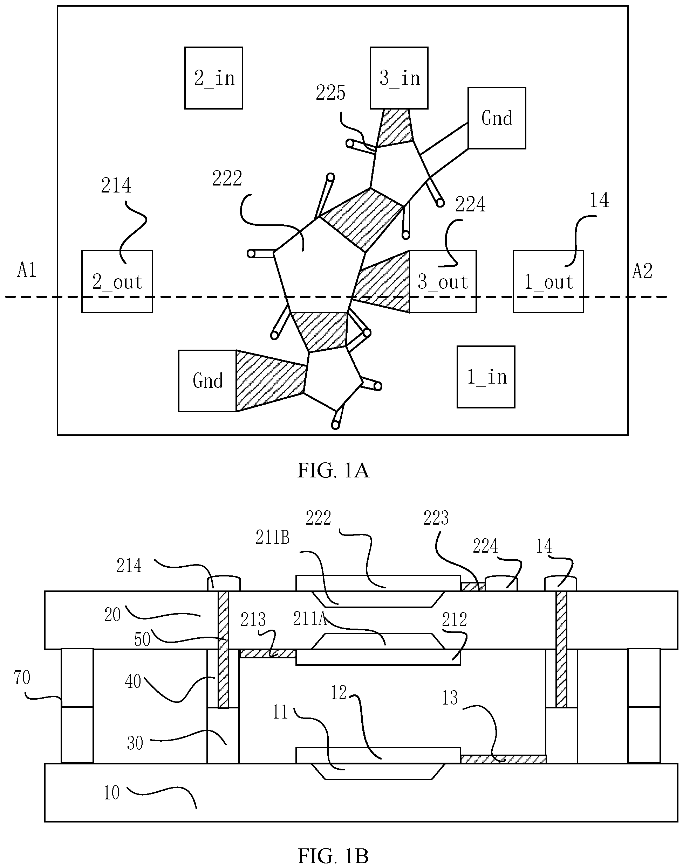

In the present disclosure, the reference signs are described as follows.
10 indicates a first substrate, which may be made of a material such as monocrystalline silicon, gallium arsenide, sapphire, and quartz.
20 indicates a second substrate, which may be made of a material such as monocrystalline silicon, gallium arsenide, sapphire, and quartz.
11 indicates a first acoustic component, which is an air cavity in the first substrate. In the present disclosure, the acoustic component is optionally an acoustic component, such as an SAW (surface acoustic wave) type or a BAW (bulk acoustic wave) type, may be a resonator, a filter, a duplexer, a multiplexer or the like, and the acoustic component may include a bulk acoustic wave resonator or a surface acoustic resonator.
12 indicates a resonant structure of the first acoustic component. For example, as shown in FIG. 1B, the acoustic component may be a bulk acoustic wave resonator, which includes, but is not limited to an acoustic mirror that may be a cavity (corresponding to an air cavity mentioned behind), or a Bragg reflection layer or other equivalent forms; a bottom electrode, which may be made of a material such as molybdenum, ruthenium, gold, aluminum, magnesium, tungsten, copper, titanium, iridium, osmium, chromium, or a compound or an alloy of the above metals; a piezoelectric film layer, which may be made of a monocrystalline piezoelectric film material such as aluminum nitride, zinc oxide, PZT, lithium niobate, lithium tantalate, and potassium niobate, and a polycrystalline piezoelectric film material, and contains a rare earth element doped material with a certain atomic ratio of the above materials; and a top electrode, which may be made of a material such as molybdenum, ruthenium, gold, aluminum, magnesium, tungsten, copper, titanium, platinum, iridium, osmium, chromium, or a compound or an alloy of the above metals.
13 indicates an electrode lead of the first acoustic component, which may be made of a material for manufacturing the electrode.
14 indicates an external pad or a conductive pad (pad) of the first acoustic component, which may be made of a material such as molybdenum, ruthenium, gold, aluminum, magnesium, tungsten, copper, titanium, platinum, iridium, osmium, chromium, or a compound or an alloy of the above metals.
211A indicates a second acoustic component, which is an air cavity located on a back surface (or a lower side) of the second substrate.
212 indicates a resonant structure of the second acoustic component, and as shown in the figure, the acoustic component may be a bulk acoustic wave resonator.
213 indicates an electrode lead of the second acoustic component, which may be made of a material for manufacturing the electrode.
214 indicates an external pad or a conductive pad of the second acoustic component, which may be made of a material for manufacturing the pad 14.
211B indicates a third acoustic component, which is an air cavity located on a front surface (or an upper side) of the second substrate.
222 indicates a resonant structure of the third acoustic component, and as shown in the figure, the acoustic component may be a bulk acoustic wave resonator.
223 indicates an electrode lead of the third acoustic component, which may be made of a material for manufacturing the electrode.
224 indicates an external pad or a conductive pad of the third acoustic component, which may be made of a material for manufacturing the pad 14.
225 indicates a sacrificial-layer material releasing channel of the third acoustic component, which is used to form the air cavity.
30 indicates a metal bonding structure, which is located on the first substrate and bonded to the second substrate, and has an electrical lead function. The metal bonding structure may be made of a material such as molybdenum, ruthenium, gold, aluminum, magnesium, tungsten, copper, titanium, platinum, iridium, osmium, chromium, or a compound or an alloy of the above metals.
40 indicates a metal electrode structure, which is located on the second substrate and bonded to the first substrate, and has an electrical lead function. The metal electrode structure may be made of a material such as molybdenum, ruthenium, gold, aluminum, magnesium, tungsten, copper, titanium, platinum, iridium, osmium, chromium, or a compound or an alloy of the above metals.
50 indicates a through hole, which passes through the second substrate and has an electrical lead function. A conductive metal is provided in the through hole, and may be made of a metal material such as molybdenum, ruthenium, gold, aluminum, magnesium, tungsten, copper, titanium, platinum, iridium, osmium, chromium, or a compound or an alloy of the above metals.
60, 601 and 602 indicate sacrificial layer connection holes. It should be noted that the number of the connection holes is not limited to one, and there may be a plurality of connection holes.
70 indicates a sealing ring, the material of which is not limited to a conductive metal (such as, gold, copper, and aluminum), and may include other non-conductive materials (such as, resin and plastic). The sealing ring 70 is an integral closed structure, which is provided on an edge between two adjacently stacked substrates to provide sealing and protecting functions. The structure is independent of the inventive concept of the present disclosure, and thus is only shown in FIG. 1B and is not drawn in subsequent figures.

FIG. 1A is a schematic top view of a semiconductor structure according to an exemplary embodiment of the present disclosure. In the present disclosure, in represents input, out represents output, and Gnd represents ground. In the example shown in FIG. 1A, there are three input and three output, which respectively correspond to the input and output of the first acoustic component, the second acoustic component and the third acoustic component, and two grounded of the third acoustic component.

FIG. 1B is a schematic sectional view along a dashed line in FIG. 1A according to an exemplary embodiment of the present disclosure.

In FIG. 1B, a first unit and a second unit are sequentially stacked in a thickness direction of a semiconductor structure. The first unit includes a first substrate 10, the second unit includes a second substrate 20, and an accommodating space is defined between the stacked first and second units. First acoustic component corresponding to reference signs 11, 12, and 13 are provided on an upper side of the first substrate 10. The second substrate 20 is a double-side functional substrate, and two sides of which are respectively provided with a second acoustic component corresponding to reference signs 212, 211A, and 213 and a third acoustic component corresponding to reference signs 222, 211B, and 223.

It can be seen from FIG. 1B that, three acoustic components are provided with respect to the two substrates, such that the number of substrates is less than the number of acoustic components.

In the present disclosure, the acoustic component on the outermost side may be protected by film packaging during subsequent chip-level packaging, or may be further packaged by a capping layer substrate similar to that shown in FIG. 7, which are all within the scope of the present disclosure.

As shown in FIG. 1B, bulk acoustic wave resonators are arranged on two sides of the second substrate 20, which is used as the two-side functional substrate. However, the present disclosure is not limited thereto, for example, the two sides of the double-side functional substrate are respectively provided with a surface acoustic wave component, or the two sides of the double-side functional substrate are respectively provided with a surface acoustic wave component and a bulk acoustic wave component. In an embodiment, the upper side of the second substrate 20 may be provided with an air cavity used as an acoustic mirror of the bulk acoustic wave resonator, and the lower side of the second substrate 20 may be provided with the surface acoustic wave resonator instead of the air cavity. These solutions and equivalents thereof are all within the scope of the present disclosure.

As shown in FIG. 1B, air cavities 11, 211A and 211B used as cavities are acoustic mirrors of corresponding acoustic components. The acoustic mirror is not limited to the air cavity, and may be a Bragg reflection layer or other equivalent structure. Although not shown, the Bragg reflection layer may be arranged in the air cavity or arranged on the surface of the substrate.

As shown in FIG. 1B, the air cavities on the upper and lower sides of the second substrate 20 are opposite to each other. In an optional embodiment, a thickness of a portion of the substrate between the cavities on the two sides of the second substrate is not less than 20 µm.

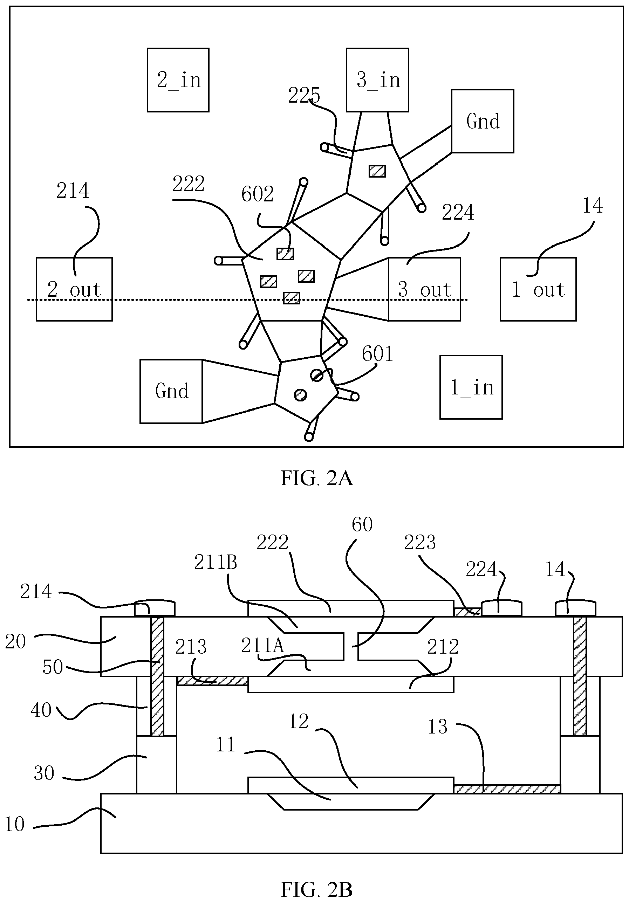

FIG. 2A is a schematic top view of a semiconductor structure according to another exemplary embodiment of the present disclosure, and FIG. 2B is a schematic sectional view along a dashed line in FIG. 2A according to another exemplary embodiment of the present disclosure. The structure shown in FIG. 2B differs from the structure shown in FIG. 1B in that a releasing hole 60 for communicating the air cavities on the two sides of the second substrate 20 is provided in FIG. 2B, such that the two air cavities communicate with each other.

In FIG. 2A, 601 and 602 correspond to two forms of the releasing hole 60, which are both arranged within an effective region of the resonator, and of which cross-sectional shapes may be a circle, a square, or other shapes.

As mentioned hereafter, during a manufacturing process of the structure shown in FIG. 1B, the air cavity 211A on the lower side of the second substrate 20 needs to be formed firstly, and the air cavity 211B is then formed on the upper side of the second substrate 20. In other words, the two air cavities in FIG. 1B are formed separately, or the air cavity on the lower side is formed before the upper side of the second substrate is thinned. The air cavity on the upper side is formed after the thinning operation.

As mentioned hereafter, during a manufacturing process of the structure shown in FIG. 2B, the air cavities on the upper and lower sides of the second substrate communicate with each other through the releasing hole 60, such that a releasing channel that communicates with the air cavity on the upper side of the second substrate can releasing a sacrificial layer material in the air cavity located on the upper side and a sacrificial layer material in the air cavity located on the lower side. In this way, when the thinning operation is performed on the upper side of the second substrate, the sacrificial layer material in the air cavity located on the lower side functions to reinforce the second substrate since it is not removed. Since the firmness of the second substrate is enhanced, the thickness of the second substrate 20 can be further reduced, such that the space volume occupied by the semiconductor structure can be reduced.

As shown in FIG. 2B, in an optional embodiment, the thickness of the second substrate having the cavities on the two sides thereof includes depths of the air cavities on the upper side and the lower side, and is in a range of 6 µm to 50 µm.

As shown in FIG. 2B, in an optional embodiment, the thickness of the portion of the second substrate between the cavities located on the two sides of the second substrate is not less than 5 µm.

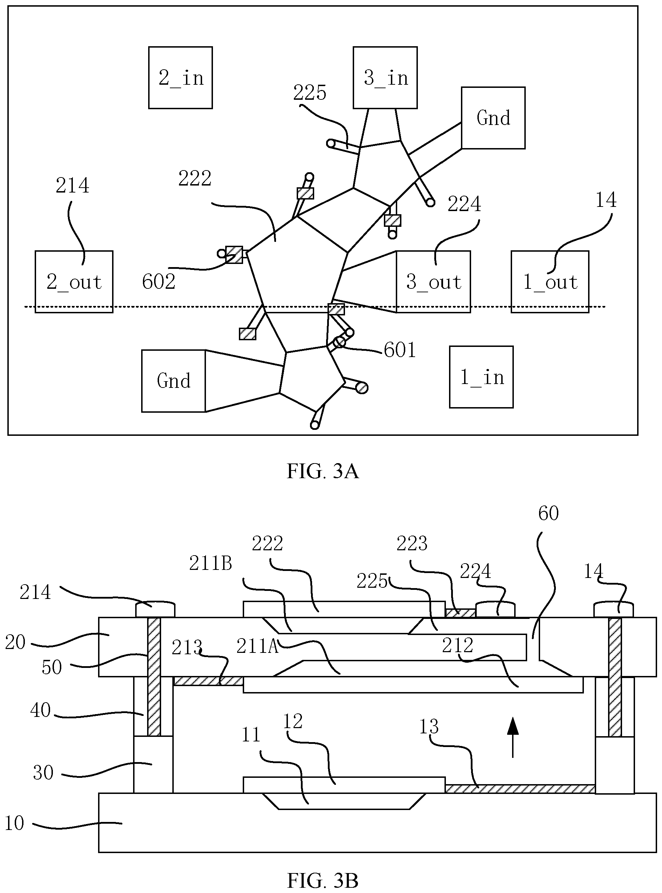

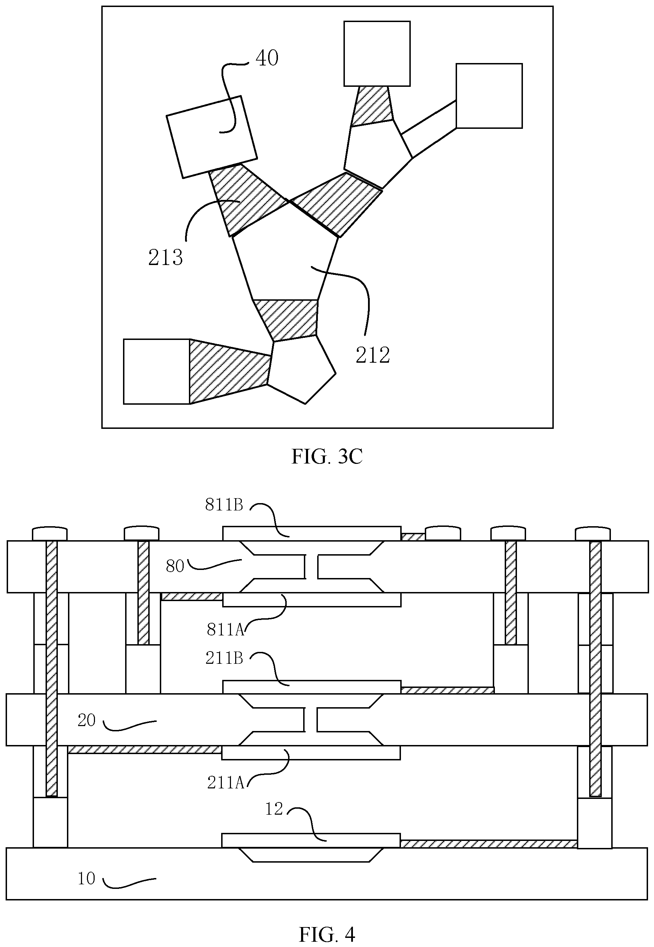

The position of the releasing hole 60 is not limited to be in the effective region of the resonator. FIG. 3A is a schematic top view of a semiconductor structure according to yet another exemplary embodiment of the present disclosure, and FIG. 3B is a schematic sectional view along a dashed line in FIG. 3A according to yet another exemplary embodiment of the present disclosure. FIG. 3B differs from FIG. 2B in that the releasing hole 60 is formed outside the effective region of the resonator in FIG. 3B. Specifically, in FIG. 3B, the releasing hole 60 is formed at the position of the releasing channel 225. An upper opening of the releasing hole 60 is open to the releasing channel 225 corresponding to the upper air cavity 211B, a lower opening of the releasing hole 60 is open to the lower air cavity 211A, and the components of the bulk acoustic wave resonator on the lower side of the double-side functional substrate cover the entire lower air cavity 211A. The covering the entire lower air cavity 211A by the components of the bulk acoustic wave resonator herein means that there is no channel or hole entering the lower air cavity 211A from inside of the accommodating space or a packaging space. FIG. 3C is a bottom view as viewed in a direction of an arrow in FIG. 3B. As shown in FIG. 3C, there is no releasing hole or releasing channel for releasing the sacrificial layer material in the air cavity 211A on the bulk acoustic wave resonators on the lower side and the lower side of the second substrate.

In FIG. 3A, 601 and 602 correspond to two forms of the releasing hole 60 that are both arranged outside the effective region of the resonator, and the cross-sectional shapes thereof may be a circle, a square, or other shapes.

Based on the structure of FIG. 3B, after the upper side of the second substrate is thinned, since the upper opening of the releasing hole 60 is open to the releasing channel 225 corresponding to the upper air cavity 211B and the lower opening of the releasing hole 60 is open to the lower air cavity 211A, the sacrificial layer materials in the air cavities located on the upper and lower sides of the second substrate are simultaneously released from the releasing channel 225. The structure of FIG. 3B can achieve the same technical effects as the structure of FIG. 2B.

In the structures shown in FIG. 2B and FIG. 3B, in an exemplary embodiment of the present disclosure, the thickness of the second substrate used as a double-side functional substrate may be in the range of 6 µm to 50 µm.

In the above embodiments, only two stacked units are shown, that is, the two substrates are stacked, but the present disclosure is not limited thereto. More units may be stacked on the semiconductor structure. FIG. 4 is a schematic sectional view along a dashed line similar to that of FIG. 1A according to yet another exemplary embodiment of the present disclosure. Compared with the previous embodiments, a third unit is provided in FIG. 4. The third unit is an uppermost unit stacked on the upper side of the second unit, in which the second unit is arranged at the middle of the units. The third unit includes a third substrate 80 and two acoustic components located on the upper and lower sides of the third substrate, for example, filters. In the embodiment shown in FIG. 4, the filter is a bulk acoustic wave filter. In the embodiment shown in FIG. 4, the number of substrates is increased, thereby increasing the number of acoustic components. Specifically, three substrates are used to integrate five filters in FIG. 4.

In the embodiment of FIG. 4, three stacked substrates are shown, but more stacked substrates may be provided.

In the stacked units, the acoustic components are only arranged on the upper side of the substrate of the lowermost unit, and each of the other substrates is a double-side functional substrate. If all acoustic components arranged on one side of each substrate are collectively referred to as an integrated acoustic component that may include only one acoustic device, 2N-1 acoustic components can be integrated by using N (N is a natural number greater than 1) substrates, thereby greatly reducing the number of substrates and further reducing the volume of the entire semiconductor structure.

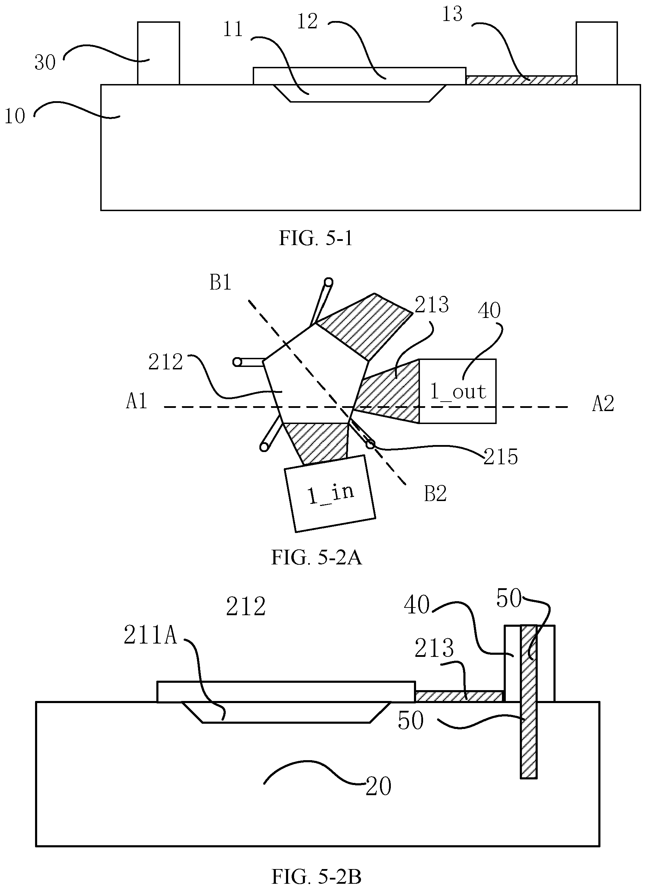

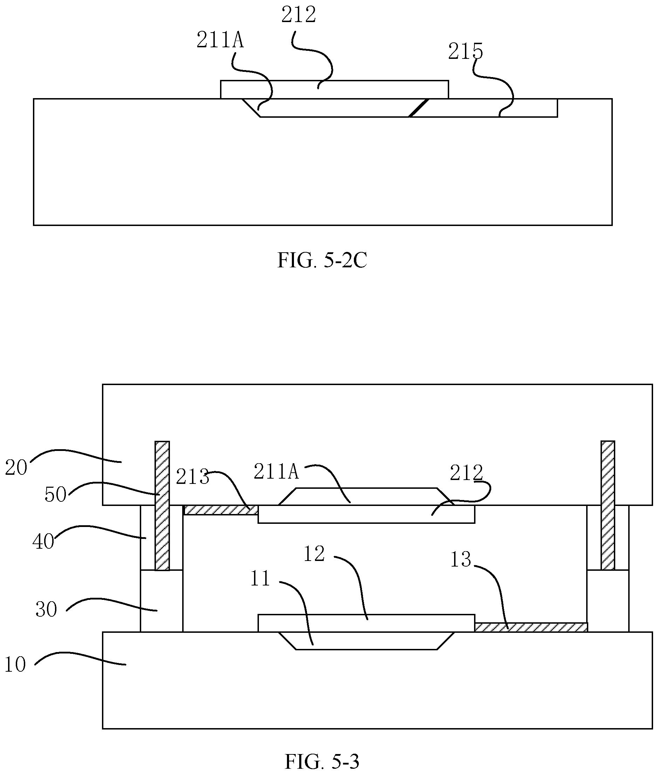

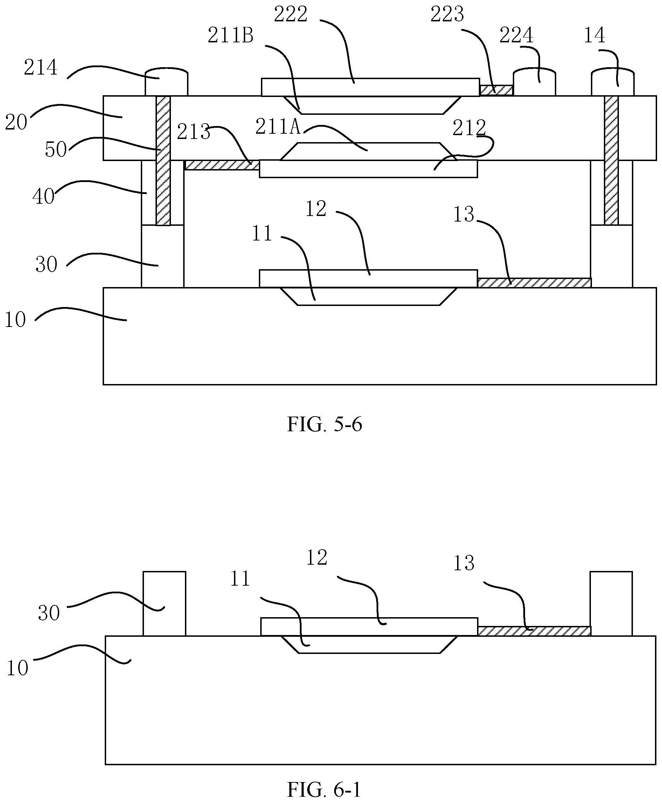

The manufacturing process of the structure of FIG. 1B is illustrated below with reference to FIG. 5-1, FIGS. 5-2Ato 5-2C, and FIGS. 5-3 to 5-6.

Step 1 is to manufacture a first unit, as shown in FIG. 5-1. A first acoustic component, such as an FBAR component, is formed on the first substrate 10, in which a standard FBAR process may be utilized and thus no repeated description will be given herein. As shown in FIG. 5-1, for example, acoustic components of the bulk acoustic wave resonator include a bottom electrode, a piezoelectric layer, a top electrode, a cavity 11, and an external lead or electrode lead 13. In addition, as shown in FIG. 5-1, a first metal bonding layer 30 is formed. In the illustration of the manufacturing process of the present disclosure, the manufacturing of the sealing layer 70 is not shown.

Step 2 is to manufacture a second unit, as show in FIGS. 5-2A to 5-2C. A second acoustic component is formed on the second substrate 20. Compared with the structure of the first unit shown in FIG. 5-1, an external lead hole 50 is formed in FIG. 5-2B, and the hole 50 is formed in a metal bonding layer 40 and extends into a part of the second substrate 20.

FIG. 5-2A is a partial top view of the second unit that is provided with the second acoustic component, FIG. 5-2B is a sectional view along line A1-A2 in FIG. 5-2A, and FIG. 5-2C is a sectional view along line B1-B2 in FIG. 5-2A. As can be seen from FIG. 5-2C, the air cavity 211A is formed by injecting a solution (e.g., hydrofluoric acid) through the releasing channel 215 for the sacrificial layer material and releasing a reaction product.

As shown in FIG. 5-3, step 3 is to place the second substrate 20 upside down on the first substrate 10, and perform a bonding connection through the first metal bonding structure 30 and the second metal bonding structure 40.

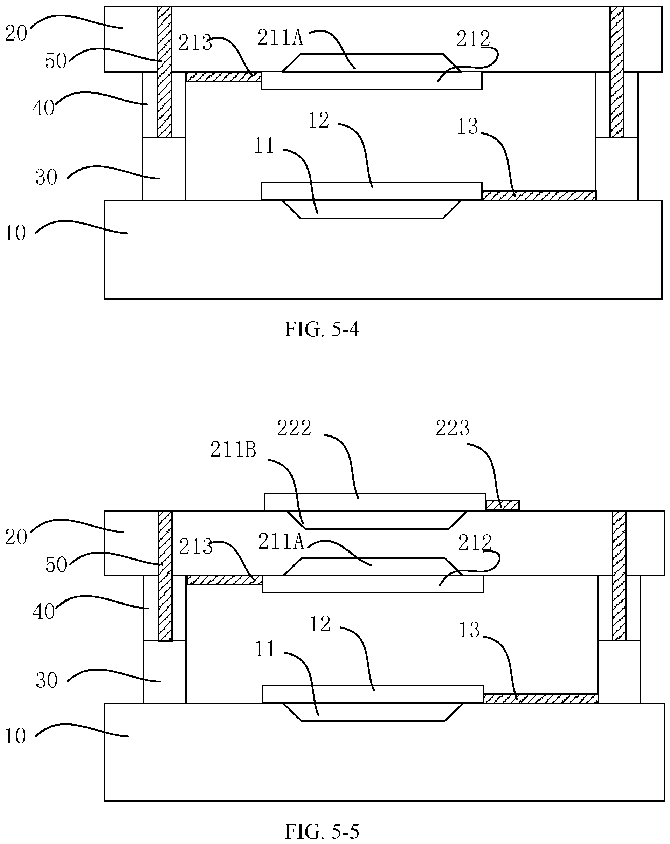

As shown in FIG. 5-4, step 4 is to thin the second substrate 20 from the back surface. For example, the second substrate is thinned by a CMP (chemical mechanical polishing) method until the hole 50 is exposed, so that the hole 50 is a conductive through hole. It should be noted that, due to the presence of the air cavity 211A, the firmness of the second substrate 20 needs to be considered. Accordingly, the thinned thickness needs to be controlled. In general, the depth of the air cavity 21 1A of the second substrate 20 is in a range of 0.5 µm to 10 µm, and is assumed to be 3 µm in an embodiment. In this way, the thickness of the thinned second substrate 20 should be controlled to be 3 µm +20 µm or more to prevent or reduce the risk of cracking and avoid influence on the process yield.

As shown in FIG. 5-5, step 5 is to form a third acoustic component, such as an FBAR component, on the back surface of the second substrate 20, in which the standard FBAR process may be utilized and thus no repeated description will be given herein. The difference from that of FIG. 5-1 is only in that the first substrate is replaced with the structure obtained by bonding the first substrate and the second substrate, which is used as an integral substrate.

As shown in FIG. 5-6, step 6 is to form external electrical lead pads 14, 214, and 224 of the first acoustic component, the second acoustic component, and the third acoustic component on the back surface of the second substrate 20. It should be noted that, since the external leads of the first acoustic component and the second acoustic component are provided on a plane where the third acoustic component is located except for its own components and external leads. In order to minimize the overall planar area, the area of the third acoustic component is smaller than those of the first acoustic component and the second acoustic component. As for the FBAR, the frequency of the third acoustic component is higher than those of the first acoustic component and the second acoustic component.

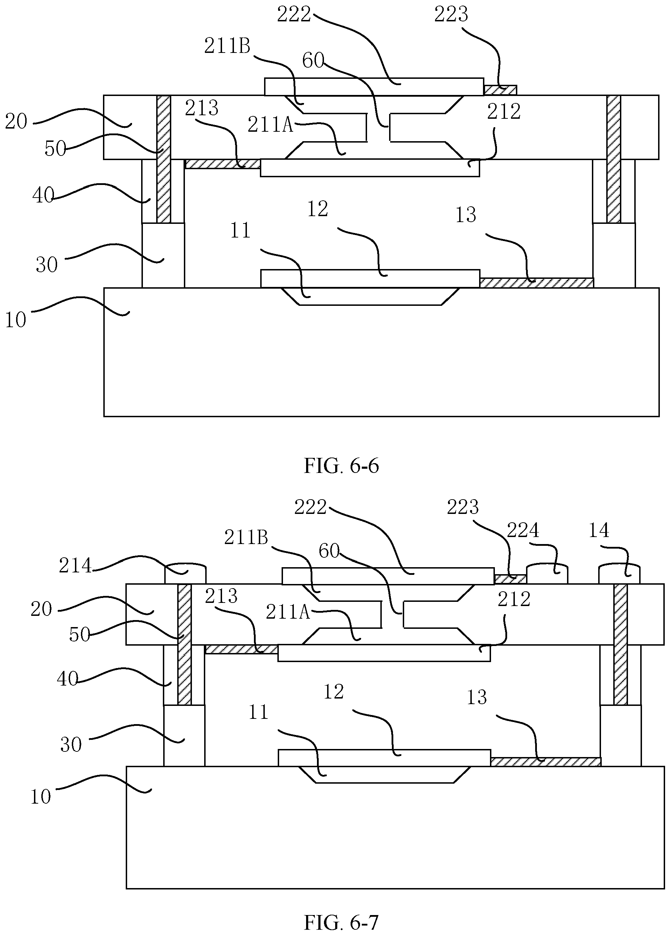

The manufacturing process of the structure of FIG. 2B is illustrated below with reference to FIGS. 6-1 to 6-7.

Referring to FIG. 6-1, step 1 is to manufacture a first unit. As shown in FIG. 6-1, a first acoustic component, such as an FBAR component, is formed on the first substrate 10, in which the standard FBAR process may be utilized and thus no repeated description will be given herein. As shown in FIG. 6-1, for example, acoustic components of the bulk acoustic wave resonator include a bottom electrode, a piezoelectric layer, a top electrode, a cavity 11, and an external lead or electrode lead 13. In addition, as shown in FIG. 6-1, a first metal bonding layer 30 is formed. In the illustration of the manufacturing process of the present disclosure, the manufacturing of the sealing layer 70 is not shown.

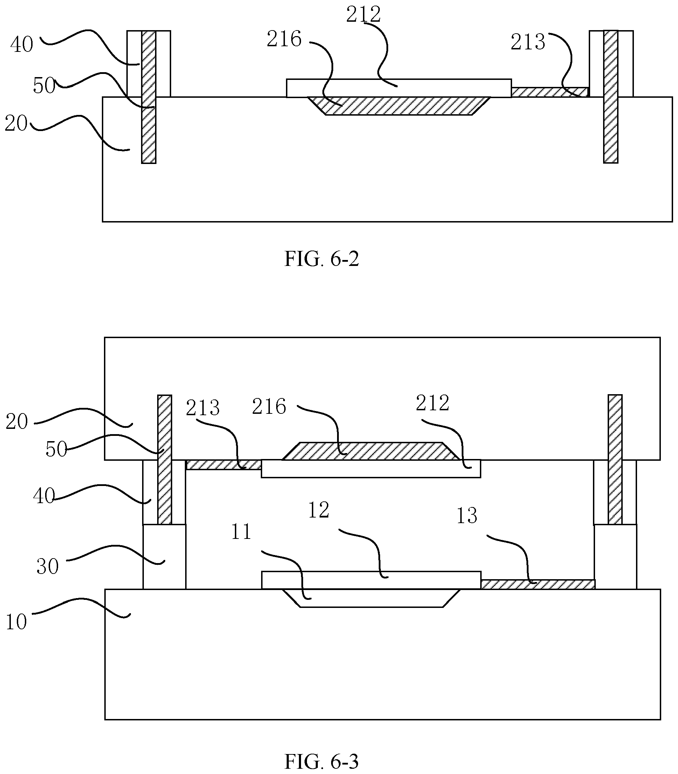

As shown in FIG. 6-2, step 2 is to manufacture a second unit, and a second acoustic component is formed on the second substrate 20. Compared with the structure of the first unit shown in FIG. 6-1, external lead holes 50 are formed in FIG. 6-2, and the holes 50 are formed in a metal bonding layer 40 and extend into a part of the second substrate 20.

Compared with FIG. 5-2B, a sacrificial layer 216 is not released in FIG. 6-2 to function to reinforce the second substrate 20 during a subsequent thinning process.

As shown in FIG. 6-3, step 3 is to place the second substrate 20 upside down on the first substrate 10, and to perform a bonding connection through the first metal bonding structure 30 and the second metal bonding structure 40.

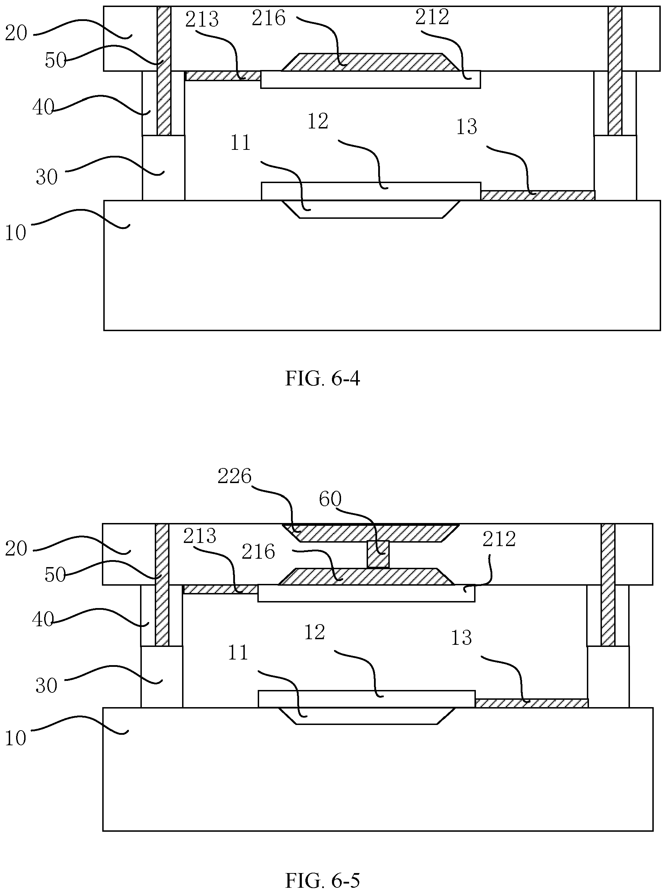

As shown in FIG. 6-4, step 4 is to thin the second substrate 20 from the back surface. For example, the second substrate is thinned by the CMP (chemical mechanical polishing) method until the holes 50 are exposed, so that the holes 50 are conductive through holes. It should be noted that, due to the presence of the sacrificial layer 216, the firmness of the second substrate 20 is improved, and therefore the thickness of the second substrate can be further reduced compared with the structure in FIG. 1B. In general, the depth of the air cavity 211A formed on the front surface of the second substrate is in the range of 0.5µm to 10 µm, and is assumed to be 3 µm.

In an embodiment of the present disclosure, phosphor silicate glass (PSG) is used as a sacrificial layer material, and has a density of about 2.2 g/cm³, which is substantially equivalent to that of a silicon substrate since the density of silicon is about 2.3 g/cm³. Borosilicate glass, boro-phosphor silicate glass and silicon dioxide all have similar properties. Accordingly, the thickness of the thinned second substrate should be controlled to be 3 µm+5 µm or more. If polyimide with a lower density is used as the sacrificial layer material, the density thereof is about 1.4 g/cm³. Compared with silicon, the mechanical strength of polyimide is poor, such that the thickness of the thinned second substrate 20 should be controlled to be 3 µm +10 µm or more. In the present disclosure, in an embodiment, the density of the sacrificial material filled in the lower cavity is 80% or more of the density of the substrate, and the thickness of the thinned second substrate is in the range of 6 µm to 50 µm. In an another embodiment, when the density of the sacrificial material filled in the lower cavity is less than 80% of the density of the substrate, the thickness of the thinned second substrate is in a range of 11 µm to 50 µm.

As shown in FIG. 6-5, step 5 is to form a sacrificial layer 216 and a sacrificial layer connection hole 60 of the third acoustic component. The sacrificial layer connection hole 60 is used to remove the sacrificial layer 216 when the sacrificial layer 216 is subsequently removed, to complete the manufacturing of the air cavities of the second acoustic component and the third acoustic component. It should be noted that, since a photoresist coating process needs to be performed subsequently, in an embodiment of the present disclosure, a diameter of the sacrificial layer connection hole 60 is selected to range from 0.5 µm to 20 µm, to prevent photoresist from flowing into the connection hole 60 during a subsequent photoresist coating process.

As shown in FIG. 6-6, step 6 is to form a subsequent structure of the third acoustic component. While the sacrificial layer 216 of the third acoustic component is removed to form the air cavity 211B, the sacrificial layer 216 of the second acoustic component is removed to form the air cavity 211A.

As shown in FIG. 6-7, step 7 is to form external electrical lead pads 14, 214, and 224 of the first acoustic component, the second acoustic component, and the third acoustic component on the back surface of the second substrate 20. It should be noted that, since the external leads of the first acoustic component and the second acoustic component are provided on a plane where the third acoustic component is located except for its own components and external leads. In order to minimize the overall planar area, the area of the third acoustic component is smaller than those of the first acoustic component and the second acoustic component. As for an application in which acoustic components (filters) of different frequencies are integrated, the acoustic component (filter) with the highest frequency that has the minimum area is arranged on the upper surface of the second unit as the third acoustic component.

The manufacturing process of the semiconductor structure shown in FIG. 3B is similar to the manufacturing process of FIG. 2B, except that during the manufacturing process of the structure shown in FIG. 3B, when the second acoustic component is formed on the front surface of the second substrate, the air cavity 211A that is correspondingly filled with the sacrificial layer material extends to the lower side of the releasing channel located on the back surface of the second substrate. Other components of the second acoustic component completely cover the air cavity 211A.

The manufacturing process of the structure shown in FIG. 4 is similar to that of FIG. 2B, and the step of processing the second substrate 20 is repeated on the third substrate 80, i.e., step 2 to step 6. Step 7 is finally performed to form the external lead.

It should be noted that, in the present disclosure, in addition to explicitly indicating that endpoint values are not included, in addition to being able to be endpoint values, the numerical value ranges may also be median values of various numerical ranges, which are all within the protection scope of the present disclosure.

In the present disclosure, upper and lower are described based on the bottom surface of the substrate (of which one side is not provided with an acoustic component) on the lowermost side of the unit, which is only provided with the acoustic component on a single side. In an upright direction, a side of the other components closer to the bottom surface is the lower side, and the side further away from the bottom surface is the upper side.

Based on the above description, the present disclosure provides the following technical solutions.
1. A semiconductor structure having stacked units includes:
   at least two units sequentially stacked in a thickness direction of the semiconductor structure, each of the at least two units including a substrate, and an accommodating space being provided between substrates of adjacently stacked upper unit and lower unit,
   wherein the at least two units include an uppermost unit and a lowermost unit, the substrate of at least one of the at least two units, other than the lowermost unit, is a double-side functional substrate, and upper and lower sides of the double-side functional substrate are provided with acoustic components, respectively;
   wherein the two sides of the double-side functional substrate are respectively provided with bulk acoustic wave components, or the two sides of the double-side functional substrate are respectively provided with a surface acoustic wave component and a bulk acoustic wave component; and wherein the bulk acoustic wave component includes a bulk acoustic wave resonator, one of the two sides of the double-side functional substrate where the bulk acoustic wave resonator is arranged is provided with a cavity, the cavity forms or is configured to define an acoustic mirror of the bulk acoustic wave resonator, and the cavity is arranged in the double-side functional substrate in a recessed manner.
2. The semiconductor structure according to 1, wherein
   the two sides of the double-side functional substrate are provided with surface acoustic wave components, respectively.
3. The semiconductor structure according to 1, wherein
   the two sides of the double-side functional substrate are respectively provided with bulk acoustic wave resonators, the two sides of the double-side functional substrate are both provided with the cavities, and the cavities on the two sides of the double-side functional substrate are opposite to each other in a thickness direction of the double-side functional substrate.
4. The semiconductor structure according to 3, wherein
   the cavities on the two sides of the double-side functional substrate communicate with each other through at least one releasing hole.
5. The semiconductor structure according to 4, wherein
   an upper end and a lower end of the at least one releasing hole are open to the cavities, respectively; or an upper end of the at least one releasing hole is open to a releasing channel corresponding to the cavity on an upper side of the two sides of the double-side functional substrate, a lower end of the at least one releasing hole is open to the cavity on a lower side of the two sides of the double-side functional substrate, and components of one of the bulk acoustic wave resonators that is arranged on the lower side of the double-side functional substrate cover the entire cavity on the lower side.
6. The semiconductor structure according to 5, wherein
   the double-side functional substrate has a thickness in a range of 6 µm to 50 µm; and/or the releasing hole has a diameter in a range of 0.5 µm to 20 µm.
7. The semiconductor structure according to 4, wherein
   a portion of the substrate that is located between the cavities on the two sides of the double-side functional substrate has a thickness, which is not less than 5 µm.
8. The semiconductor structure according to 1, wherein
   the substrate of the lowermost unit is provided with acoustic components on an upper surface thereof.
9. The semiconductor structure according to 8, wherein
   the acoustic components on one side of each of the substrates form an integrated acoustic component; and the semiconductor device includes N stacked substrates and 2N-1 integrated acoustic components, and N is a natural number greater than 1.
10. The semiconductor structure according to any one of 1-9 further includes:
   a plurality of conductive through holes, each of the plurality of conductive through holes passing through the substrate of the uppermost unit and extending downwards in the thickness direction to be electrically connected to a corresponding one of the at least two units.
11. The semiconductor structure according to 10, wherein
   the substrate of the uppermost unit is a double-layer functional substrate, and the acoustic components arranged on two sides of the double-layer functional substrate include bulk acoustic wave resonators; and an upper end of the conductive through hole is open to an upper surface of the substrate of the uppermost unit, and a sum of areas of effective regions of the bulk acoustic wave resonators on the upper side of the substrate of the uppermost unit is less than a sum of areas of effective regions of the bulk acoustic wave resonators on the lower side of the substrate of the uppermost unit.
12. A method of manufacturing a semiconductor structure with stacked units includes the steps of:
   providing a first substrate that is provided with a first acoustic component on an upper side thereof;
   providing a second substrate that is provided with a lower acoustic component on a lower side thereof;
   arranging the first substrate and the second substrate to be opposite each other, and providing an accommodating space between the upper side of the first substrate and the lower side of the second substrate, the first acoustic component and the lower acoustic component being located in the accommodating space;
   providing an upper acoustic component on an upper side of the second substrate; and
   providing a lower acoustic component on the lower side of the second substrate,
   wherein the step of providing the lower acoustic component on the lower side of the second substrate includes forming a lower cavity on the lower side of the second substrate, the lower cavity is recessed into the second substrate, and the lower acoustic component of the second substrate includes a bulk acoustic wave resonator of which an acoustic mirror is arranged in the lower cavity; and
   wherein the step of providing the upper acoustic component on the upper side of the second substrate includes forming an upper cavity opposite to the lower cavity on the upper side of the second substrate, a spacer layer used as a component of the second substrate is provided between the upper cavity and the lower cavity, the upper cavity is recessed into the second substrate, and the upper acoustic component includes a bulk acoustic wave resonator of which an acoustic mirror is arranged in the upper cavity.
13. The method according to 12, wherein
   the first substrate is provided with a first metal bonding layer on the upper side thereof, the second substrate is provided with a second metal bonding layer on the lower side thereof, and the first metal bonding layer and the second metal bonding layer are configured to be bonded to each other when the first substrate and the second substrate are arranged oppositely;
   the step of providing the second substrate includes providing a conductive blind hole on the lower side of the second substrate, and the conductive blind hole has an open end electrically connected to the second metal bonding layer; and
   before the step of providing the upper acoustic component on the upper side of the second substrate, the method includes the step of thinning the second substrate from the upper side of the second substrate to expose another end of the conductive blind hole.
14. The method according to 12, wherein
   the upper cavity and the lower cavity each form an acoustic mirror of a corresponding one of the bulk acoustic wave resonators;
   the method further includes the steps of filling the lower cavity with a sacrificial material and filling the upper cavity with the sacrificial material; and
   the method further includes the steps of releasing the sacrificial layer of the upper cavity and releasing the sacrificial material of the lower cavity.
15. The method according to 14, wherein
   the upper cavity and the lower cavity communicate with each other through a releasing hole; and
   the method further includes the step of releasing the sacrificial material in the lower cavity through the releasing hole during the releasing of the sacrificial material of the upper cavity.
16. The method according to 15, wherein
   the releasing hole is located outside an effective region of the bulk acoustic wave resonator on an upper surface of the second substrate, and communicates with a releasing channel of the upper cavity.
17. The method according to 15, wherein
   the sacrificial material filled in the lower cavity has a density that is 80% or more of a density of the substrate, and the thinned second substrate has a thickness in a range of 6 µm to 50 µm; or the sacrificial material filled in the lower cavity has a density that is less than 80% of a density of the substrate, and the thinned second substrate has a thickness in a range of 11 µm to 50 µm.
18. The method according to 12, wherein
   the step of providing the lower acoustic component on the lower side of the second substrate includes releasing the sacrificial material in the lower cavity.
19. An electronic device includes the semiconductor structure according to any one of 1-11.

It should be noted that, the electronic device herein may include, but is not limited to, intermediate products such as a radio-frequency front end, and a filtering and amplifying module, and terminal products such as a mobile phone, WIFI and an unmanned aerial vehicle.

Although the embodiments of the present disclosure have been shown and described, it will be understood by those ordinary skilled in the art that changes may be made to these embodiments without departing from the principles and spirit of the present disclosure, and the scope of the present disclosure is determined by the appended claims and their equivalents.

## Claims

1. A semiconductor structure, the semiconductor structure comprising stacked units, and comprising:
at least two units sequentially stacked in a thickness direction of the semiconductor structure, each of the at least two units comprising a substrate, and an accommodating space being provided between the substrates of adjacently stacked upper unit and lower unit of the at least two units,
wherein the at least two units comprise an uppermost unit and a lowermost unit, the substrate of at least one of the at least two units, other than the lowermost unit, is a double-side functional substrate, and upper and lower sides of the double-side functional substrate are provided with acoustic components, respectively;
wherein the two sides of the double-side functional substrate are respectively provided with bulk acoustic wave components, or the two sides of the double-side functional substrate are respectively provided with a surface acoustic wave component and a bulk acoustic wave component; and
wherein the bulk acoustic wave component comprises a bulk acoustic wave resonator, one of the two sides of the double-side functional substrate where the bulk acoustic wave resonator is arranged is provided with a cavity, the cavity forms or is configured to define an acoustic mirror of the bulk acoustic wave resonator, and the cavity is arranged in the double-side functional substrate in a recessed manner.

2. The semiconductor structure according to claim 1, wherein the two sides of the double-side functional substrate are provided with surface acoustic wave components, respectively.

3. The semiconductor structure according to claim 1, wherein the two sides of the double-side functional substrate are respectively provided with bulk acoustic wave resonators, the two sides of the double-side functional substrate are both provided with the cavities, and the cavities on the two sides of the double-side functional substrate are opposite each other in a thickness direction of the double-side functional substrate.

4. The semiconductor structure according to claim 3, wherein the cavities on the two sides of the double-side functional substrate communicate with each other through at least one releasing hole.

5. The semiconductor structure according to claim 4, wherein an upper end and a lower end of the at least one releasing hole are open to the cavities, respectively; or
an upper end of the at least one releasing hole is open to a releasing channel corresponding to the cavity on an upper side of the two sides of the double-side functional substrate, a lower end of the at least one releasing hole is open to the cavity on a lower side of the two sides of the double-side functional substrate, and components of one of the bulk acoustic wave resonators that is arranged on the lower side of the double-side functional substrate cover the entire cavity on the lower side.

6. The semiconductor structure according to claim 5, wherein the double-side functional substrate has a thickness in a range of 6 µm to 50 µm; and/or
the releasing hole has a diameter in a range of 0.5 µm to 20 µm.

7. The semiconductor structure according to claim 4, wherein a portion of the substrate that is located between the cavities on the two sides of the double-side functional substrate has a thickness, which is not less than 5 µm.

8. The semiconductor structure according to claim 1, wherein the substrate of the lowermost unit is provided with acoustic components on an upper surface thereof.

9. The semiconductor structure according to claim 8, wherein the acoustic components on one side of each of the substrates form an integrated acoustic component; and
the semiconductor device comprises N stacked substrates and 2N-1 integrated acoustic components, and N is a natural number greater than 1.

10. The semiconductor structure according to any one of claims 1-9, further comprising:
a plurality of conductive through holes, each of the plurality of conductive through holes passing through the substrate of the uppermost unit and extending downwards in the thickness direction to be electrically connected to a corresponding one of the at least two units.

11. The semiconductor structure according to claim 10, wherein the substrate of the uppermost unit is a double-layer functional substrate, and the acoustic components arranged on two sides of the double-layer functional substrate comprise bulk acoustic wave resonators; and
an upper end of the conductive through hole is open to an upper surface of the substrate of the uppermost unit, and a sum of areas of effective regions of the bulk acoustic wave resonators on the upper side of the substrate of the uppermost unit is less than a sum of areas of effective regions of the bulk acoustic wave resonators on the lower side of the substrate of the uppermost unit.

12. A method of manufacturing a semiconductor structure with stacked units, comprising:
providing a first substrate that is provided with a first acoustic component on an upper side thereof;
providing a second substrate that is provided with a lower acoustic component on a lower side thereof;
arranging the first substrate and the second substrate to be opposite each other, and providing an accommodating space between the upper side of the first substrate and the lower side of the second substrate, the first acoustic component and the lower acoustic component being located in the accommodating space;
providing an upper acoustic component on an upper side of the second substrate; and
providing a lower acoustic component on the lower side of the second substrate,
wherein the providing the lower acoustic component on the lower side of the second substrate comprises forming a lower cavity on the lower side of the second substrate, the lower cavity is recessed into the second substrate, and the lower acoustic component of the second substrate comprises a bulk acoustic wave resonator of which an acoustic mirror is arranged in the lower cavity; and
wherein the providing the upper acoustic component on the upper side of the second substrate comprises forming an upper cavity opposite to the lower cavity on the upper side of the second substrate, a spacer layer used as a component of the second substrate is provided between the upper cavity and the lower cavity, the upper cavity is recessed into the second substrate, and the upper acoustic component comprises a bulk acoustic wave resonator of which an acoustic mirror is arranged in the upper cavity.

13. The method according to claim 12, wherein the first substrate is provided with a first metal bonding layer on the upper side thereof, the second substrate is provided with a second metal bonding layer on the lower side thereof, and the first metal bonding layer and the second metal bonding layer are configured to be bonded to each other when the first substrate and the second substrate are arranged oppositely;
the providing the second substrate further comprises providing a conductive blind hole on the lower side of the second substrate, and the conductive blind hole has an open end electrically connected to the second metal bonding layer; and
before the providing the upper acoustic component on the upper side of the second substrate, the method further comprises thinning the second substrate from the upper side of the second substrate to expose another end of the conductive blind hole.

14. The method according to claim 12, wherein the upper cavity and the lower cavity each form an acoustic mirror of a corresponding one of the bulk acoustic wave resonators;
the method further comprises filling the lower cavity with a sacrificial material and filling the upper cavity with the sacrificial material; and
the method further comprises releasing the sacrificial layer of the upper cavity and releasing the sacrificial material of the lower cavity.

15. The method according to claim 14, wherein the upper cavity and the lower cavity communicate with each other through a releasing hole; and
the method further comprises releasing the sacrificial material in the lower cavity through the releasing hole during the releasing of the sacrificial material in the upper cavity.

16. The method according to claim 15, wherein the releasing hole is located outside an effective region of the bulk acoustic wave resonator on an upper surface of the second substrate, and communicates with a releasing channel of the upper cavity.

17. The method according to claim 15, wherein the sacrificial material filled in the lower cavity has a density that is 80% or more of a density of the substrate, and the thinned second substrate has a thickness in a range of 6 µm to 50 µm; or
the sacrificial material filled in the lower cavity has a density that is less than 80% of a density of the substrate, and the thinned second substrate has a thickness in a range of 11 µm to 50 µm.

18. The method according to claim 12, wherein the providing the lower acoustic component on the lower side of the second substrate comprises releasing the sacrificial material in the lower cavity.

19. An electronic device, comprising the semiconductor structure according to any one of claims 1-11.
